# EUROPEAN PATENT APPLICATION

(11) **EP 3 086 204 A1**
(43) Date of publication of application: **26.10.2016**
(21) Application number: 16165934.7
(22) Date of filing: 19.04.2016
(51) Int. Cl.: G06F 1/26

(54) **AN EXECUTION METHOD OF A STORAGE DEVICE STACKING SYSTEM**

(30) Priority: 20.04.2015 TW 104112552
(71) Applicant: Walton Advanced Engineering Inc., Kaohsiung City 80681 (TW)
(72) Inventor: YU, Hong-Chi, 80681 Kaohsiung City (TW); CHANG, Mao-Ting, 80681 Kaohsiung City (TW)
(74) Representative: Viering, Jentschura & Partner mbB Patent- und Rechtsanwälte

(57) **Abstract**

An execution method of a storage device stacking system for operation of at least two stacked storage devices comprises steps as follows: a main storage device is connected to an external AC source; the main storage device transforms external AC to DC by which all components in the main storage device are electrically activated and the main storage device is connected to an external network; the main storage device is electrically connected to an auxiliary storage device for transmission of external AC; the auxiliary storage device transforms external AC to DC by which all components in the auxiliary storage device are electrically activated and the main storage device is electrically connected to the auxiliary storage device.

## Description

### BACKGROUND OF THE INVENTION

### 1) Field of the Invention

The present disclosure relates to a method with respect to a storage device assembly, particularly a method regarding power and data management for a main storage device and an expanded auxiliary storage device, both of which are electrically connected to each other for data communication, and the main storage device managing power and data totally.

### 2) Description of the Prior Art

The private cloud popularized in home networking has driven centralization management of household storage devices in which a standalone network storage device linking the home network has the function of managing centralized and backup data; however, it is difficult to promote centralization of storage capacity of network storage devices because a user needs to distribute these network storage devices and install other expanded storage devices.

Some patents with respect to storage systems are shown as follows:

TW I431473 disclosed an expanded storage system of a storage device linking a network and a method thereof. In some embodiments, TW I431473 presents an expanded storage system which comprises a shield body, a communications port (subject to a communications protocol for operable and accessible permanent storage devices based on configurations), and port extender circuits covered in the shield body and coupled with the communications port (port extender circuits installed inside multiple auxiliary ports subject to the communications protocol for operation based on configurations). According to configurations, the expanded storage system is coupled with a storage device linking a network via the communications port to promote long-term efficiency of an external storage device linking the network.

TW I286690 disclosed an expanded architecture for a peripheral storage device with a port multiplier, comprising: a host; an interface controller which comprises a plurality of serial ports for data transmission and is electrically connected to the host; a port multiplier communicating with the interface controller via signals and having a plurality of expanded ports, each of which transform parallel data to serial data; at least a peripheral storage device which features a parallel data transmission mode and signals transmitted to each of the expanded ports on the port multiplier for data transmission between the peripheral storage device and the interface controller.

TW I274353 disclosed a stacked mobile storage device which comprises a first mobile disk, at least a second mobile disk and a pluggable module: the first and second mobile disks are stacked on each other by means of the pluggable module; the pluggable module has a male plug and a female socket for assembling. Particularly, the second mobile disk with expanded capacity depends on a switch unit to link a control unit in the first mobile disk by which the second mobile disk is activated. Thus, the memory capacity of the second mobile disk can be added into that of the first mobile disk for greater capacity in which more data is stored.

TW I263878 disclosed a data storage device, particularly a data storage device with a flexible cascading function, comprising: a mode detector which determines that an external device linking an output connector includes circuits for configurations of a master mode in a main host system which controls and switches the mode detector between a master mode and a slave mode; a data read/write controller which determines an external expanded connector links another cascaded external data storage device and informs the host system of a cascaded external data storage device, if any, via the output connector; a host system which depends on any new external data storage device to configure storage media inside all cascaded data storage devices in a total capacity mode or merely takes a cascaded data storage device as an external data storage device in a supplementary device mode in order to integrate memory capacity of all internal storage media and flexibly expand service efficiency.

However, most solutions mentioned above are intended for enterprise environment rather than private environment via a simple and quick manner; moreover, the costs and know-how are required in most solutions and the options for diversified functions in these solutions are limited.

Therefore, an execution method of a storage device stacking system presented herein is intended to solve these problems.

### SUMMARY OF THE INVENTION

In view of above problems, the present disclosure describes an execution method of a storage device stacking system which comprises a main storage device for power connection, data transmission and centralization management and an auxiliary storage device for expanded storage spaces of the main storage device.

The present disclosure describes an execution method of a storage device stacking system which contributes to unified management of power/data and effective expanded storage spaces.

The present disclosure describes an execution method of a storage device stacking system with fewer limitations in expanded capacity of storage devices.

The present disclosure describes an execution method of a storage device stacking system which depends on an internal transformer unit to transform external AC to DC for fewer costs of purchasing a main storage device initially.

The present disclosure describes an execution method of a storage device stacking system which depends on various data bridging mechanisms to increase storage spaces and additional functions.

The present disclosure describes an execution method of a storage device stacking system which contributes to availability of existing equipment and decreases probability of decommissioning existing equipment.

For these purposes, an execution method of a storage device stacking system depends on technical measures as follows. In the present disclosure, an execution method of a storage device stacking system for operation of at least two stacked storage devices comprises steps as follows: step 1: a power input interface on a main storage device is connected to an external AC source; step 2: a transformer unit of a power management module in the main storage device transforms external AC transmitted through the power input interface to DC by which all components in the main storage device are electrically activated and a data link interface on the main storage device is connected to an external network; step 3: a power output interface on the main storage device is electrically connected to a power reception interface on an auxiliary storage device for transmission of external AC; step 4: an auxiliary transformer unit of an auxiliary power management module in the auxiliary storage device transforms external AC transmitted through the power reception interface to DC by which all components in the auxiliary storage device are electrically activated and a main data bridging interface on the main storage device is electrically connected to an auxiliary data bridging interface on the auxiliary storage device.

Moreover, an execution method of a storage device stacking system depends on following technical measures to realize purposes and techniques.

In the above execution method of a storage device stacking system, a data management module of the main storage device is used to manage a main storage module of the main storage device and an auxiliary storage module of the auxiliary storage device after step 4.

In the above execution method of a storage device stacking system, an auxiliary data link interface on the auxiliary storage device is connected to an external network after step 4.

In the above execution method of a storage device stacking system, the data link interface is available to a wired network or a wireless network or a combination thereof.

In the above execution method of a storage device stacking system, an expanded power output interface on the auxiliary storage device is electrically connected to a power reception interface on a second auxiliary storage device for transmission of external AC after step 4.

In the above execution method of a storage device stacking system, an auxiliary data management module of the auxiliary storage device assists the data management module in data processing after step 4.

In the above execution method of a storage device stacking system, the data management module of the main storage device is used to manage the data link interface and the auxiliary data link interface after step 4.

In the above execution method of a storage device stacking system, an auxiliary transformer unit of an auxiliary power management module in the second auxiliary storage device transforms external AC transmitted through the power reception interface to DC by which all components in the second auxiliary storage device are electrically activated and an expanded data bridging interface on the auxiliary storage device is electrically connected to an auxiliary data bridging interface on the second auxiliary storage device after step 4.

In the above execution method of a storage device stacking system, the data management module is used to manage an auxiliary storage module of the second auxiliary storage device after step 4.

In contrast to conventional techniques, an execution of a storage device stacking system has effects as follows: (1) storage capacity increased easily and quickly; (2) fewer limitations in expansion and costs because of transformer units during initial setup of a storage device stacking system; (3) data bridging promoting probable functions of other additional devices.

### BRIEF DESCRIPTIONS OF THE DRAWINGS

FIG. 1 is the first flow diagram of an execution method of a storage device stacking system in a preferred embodiment;
FIG. 2 is the second flow diagram of an execution method of a storage device stacking system in a preferred embodiment;
FIG. 3 is the third flow diagram of an execution method of a storage device stacking system in a preferred embodiment;
FIG. 4 is the first schematic view of an execution method of a storage device stacking system in a preferred embodiment;
FIG. 5 is the second schematic view of an execution method of a storage device stacking system in a preferred embodiment.

### DETAILED DESCRIPTIONS OF THE PREFERRED EMBODIMENTS

An execution method of a storage device stacking system will be further illustrated in following embodiments for clear understanding of purposes, characteristics and effects

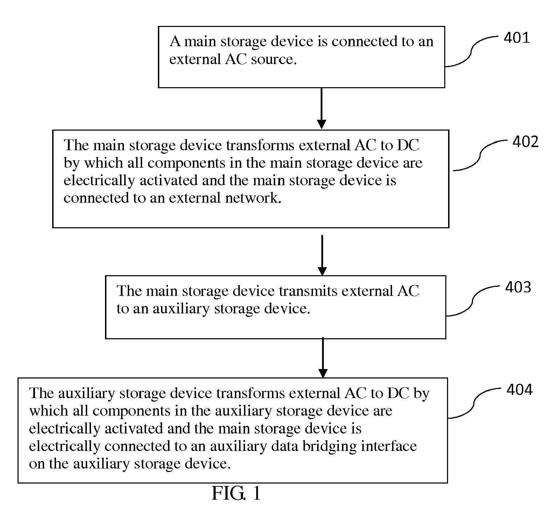

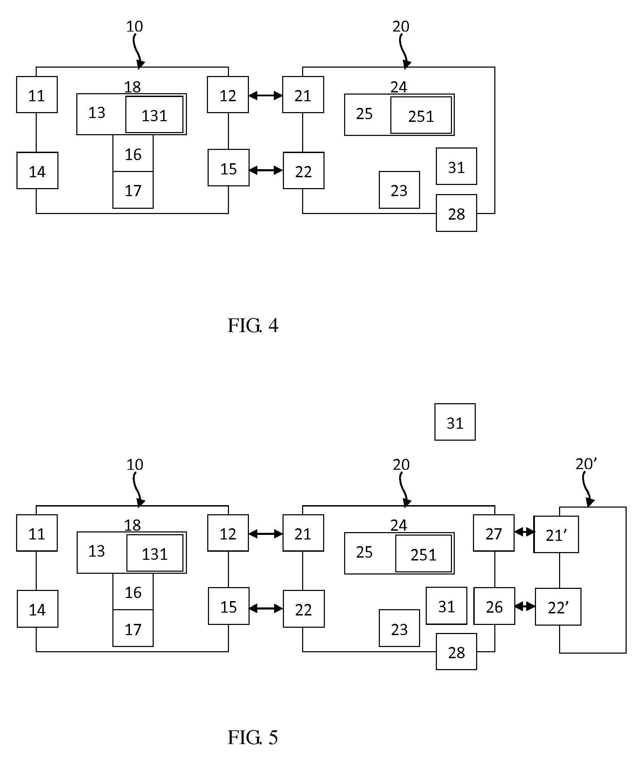

FIG. 1 through FIG. 5 illustrate an execution method of a storage device stacking system in main embodiments. Referring to FIG. 1 which illustrates an execution method of a storage device stacking system comprises step 1 (401), step 2 (402), step 3 (403) and step 4 (404) in the first embodiment; referring to FIG. 4 which is a schematic view of a storage device stacking system comprising a main storage device (10) and an auxiliary storage device (20).

Referring to FIGS. 1 and 4 which illustrate steps as follows: step 1 (401): a power input interface (11) on a main storage device (10) is connected to an external AC source; step 2 (402): a transformer unit (131) of a power management module (13) in the main storage device (10) transforms external AC transmitted through the power input interface (11) to DC by which all components in the main storage device (10) are electrically activated and a data link interface (14) on the main storage device (10) is connected to an external network; step 3 (403): a power output interface (12) on the main storage device (10) is electrically connected to a power reception interface (21) on an auxiliary storage device (20) for transmission of external AC; step 4 (404): an auxiliary transformer unit (251) of an auxiliary power management module (25) in the auxiliary storage device (20) transforms external AC transmitted through the power reception interface (21) to DC by which all components in the auxiliary storage device (20) are electrically activated and a main data bridging interface (15) on the main storage device (10) is electrically connected to an auxiliary data bridging interface (22) on the auxiliary storage device (20).

Specifically, the main storage device (10) comprises a power input interface (11), a power output interface (12), a power management module (13), a data link interface (14), a main data bridging interface (15), a data management module (16) and a main storage module (17), all of which are carried on a first board (18) and electrically connected to one another, and the power management module (13) comprises a transformer unit (131).

The power input interface (11) electrically connected to an external AC (Alternating Current) source is an interface through which the main storage device (10) accesses a power supply; the power output interface (12) is an interface which extends from the power input interface (11) and accesses an external AC (Alternating Current) source; the power management module (13) is used to manage power transmitted from an external AC (Alternating Current) source through the power input interface (11) for safe electricity of the data link interface (14), the main data bridging interface (15), the data management module (16), the main storage module (17) and the first board (18) and energy efficiency; the data link interface (14) is an interface linking an external network, wired or wireless, by which the main storage device (10) interacts with outside devices and the outside devices access relevant resources; the main data bridging interface (15) electrically connected to the auxiliary storage device (20) is used in data transmission and management of expanded resources; the data management module (16) is a microprocessor (uP) which executes complicated computer programs; the main storage module (17) is a device in which data digitized through electric, magnetic or optical media technology is stored and also an appliance for data storage based on electric or magnetic energy in general; the first board (18) is a circuit board usually, which may be a single-layered or multi-layered printed circuit board, or a lead frame, a layer of polyimide circuit film, a BT circuit board or a chip-on-board as required.

Specifically, the auxiliary storage device (20) comprises a power reception interface (21), an auxiliary data bridging interface (22) and an auxiliary storage module (23) and an auxiliary power management module (25), all of which are carried on a second board (24) and electrically connected to one another, and the auxiliary power management module (25) comprises an auxiliary transformer unit (251).

The power reception interface (21) electrically connected to an external AC (Alternating Current) source is an interface through which the auxiliary storage device (20) accesses a power supply and the power reception interface (21) accesses external AC transmitted through the power output interface (12) on the main storage device (10); the auxiliary data bridging interface (22) is electrically connected to the main data bridging interface (15) for data transmission from the data management module (16) of the main storage device (10) and management of resources of the expanded auxiliary storage device (20); the auxiliary storage module (23) is a device in which data digitized through electric, magnetic or optical media technology is stored and also an appliance for data storage based on electric or magnetic energy in general; the second board (24) is a circuit board usually, which may be a single-layered or multi-layered printed circuit board, or a lead frame, a layer of polyimide circuit film, a BT circuit board or a chip-on-board as required; the transformer unit (131) and the auxiliary transformer unit (251) are used to effectively transform Alternating Current (AC) available for interior appliances to Direct Current (DC) which is applicable to ordinary electronic components in practice.

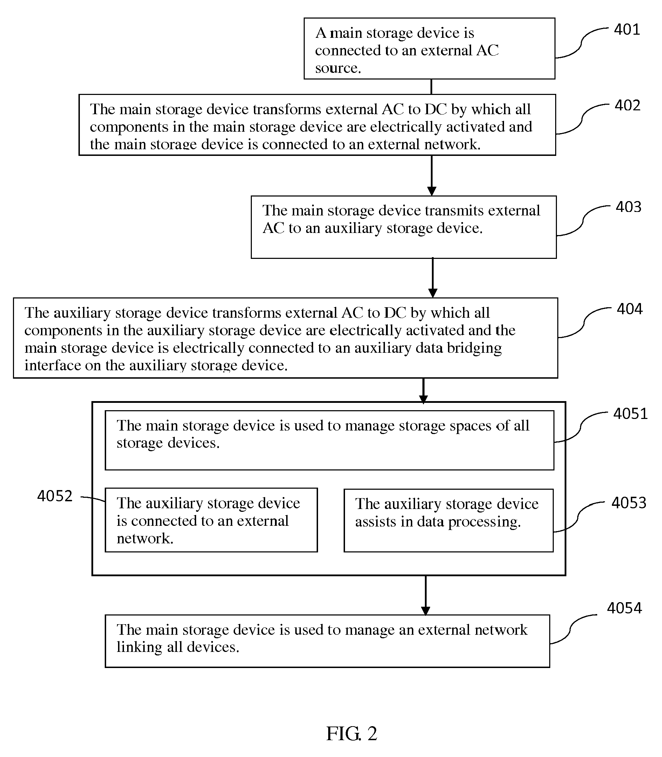

Referring to FIG. 2 that illustrates steps in an execution method of a storage device stacking system in the second embodiment in which the symbols identical to those of the first embodiment and FIGS. 1 and 4 are not explained hereinafter. The differences in the second embodiment are step 5-1 (4051), step 5-2 (4052), step 5-3 (4053) and step 5-4 (4054) after step 4 (404) in the first embodiment and used to explain management of all storage spaces and network resources under the main storage device (10).

Specifically, as shown in FIGS. 2 and 4, a storage device stacking system in the first embodiment presents network connection and storage spaces enabled in both the main storage device (10) and the auxiliary storage device (20) and refers to other steps as follows: step 5-1 (4051) for management of storage spaces in the auxiliary storage device (20); step 5-2 (4052) for the auxiliary storage device (20) linking an external network; step 5-3 (4053) for activation of data processing. In step 5-1 (4051), a data management module (16) in the main storage device (10) is used to manage the main storage module (17) in the main storage device (10) and an auxiliary storage module (23) in the auxiliary storage device (20); in step 5-2 (4052), an auxiliary data link interface (28) in the auxiliary storage device (20) is connected to an external network; in step 5-3 (4053), an auxiliary data management module (31) in the auxiliary storage device (20) assists the data management module (16) in data processing; in step 5-4 (4054), the data management module (16) in the main storage device (10) is used to manage the data link interface (14) and the auxiliary data link interface (28).

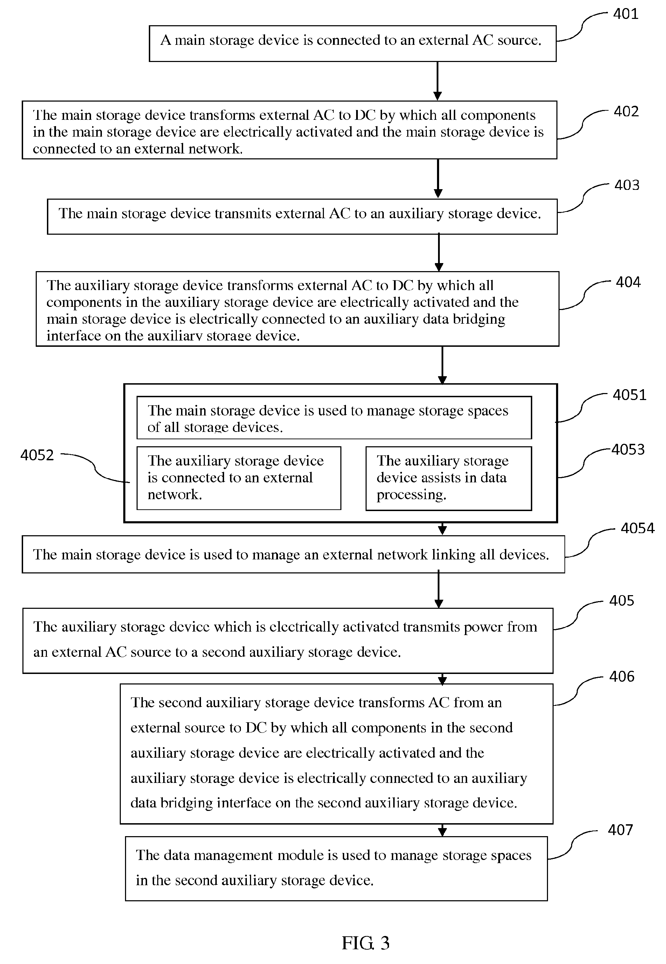

Referring to FIG. 3 which illustrates steps in an execution method of a storage device stacking system in the third embodiment in which the symbols identical to those in the second embodiment and FIGS. 2 and 4 are not explained in FIGS. 3 and 5. The differences in the third embodiment are step 5 (405), step 6 (406) and step 7 (407) after step 5-4 (4054) in the second embodiment and used to explain the embodiment in which the main storage device (10) links the auxiliary storage device (20) and further a second auxiliary storage device (20') in series.

In practice, as shown in FIGS. 3 and 5, a storage device stacking system in the second embodiment presents the auxiliary storage device (20) linking the second auxiliary storage device (20') in series and refers to other steps as follows: step 5 (405) for power supplied to the second auxiliary storage device (20'); step 6 (406) for electrical activation of components and interfaces in the second auxiliary storage device (20'); step 7 (407) for unified management of storage spaces in the second auxiliary storage device (20') under the main storage device (10). In step 5 (405), an expanded power output interface (27) electrically activated on the auxiliary storage device (20) transmits power from an external AC source to a power reception interface (21') on the second auxiliary storage device (20'); in step 6 (406), an auxiliary transformer unit of an auxiliary power management module in the second auxiliary storage device (20') transforms AC from an external source to DC by which all components in the second auxiliary storage device (20') are electrically activated and an expanded data bridging interface (26) on the auxiliary storage device (20) is electrically connected to an auxiliary data bridging interface (22') on the second auxiliary storage device (20'); in step 7 (407), the data management module (16) is used to manage an auxiliary storage module in the second auxiliary storage device (20').

Accordingly, an execution method of a storage device stacking system in the present disclosure, which differs from methods of traditional network storage devices and is referred to as creative work among applications of storage devices, meets patentability and is applied for the patent.

It should be reiterated that the above descriptions presents preferred embodiments, and any equivalent change in specifications, claims, or drawings still belongs to the technical field within the present disclosure with reference to claims hereinafter.

## Claims

1. An execution method of a storage device stacking system for operation of at least two stacked storage devices comprises steps as follows:
step 1: a power input interface on a main storage device is connected to an external AC source (401);
step 2: a transformer unit of a power management module in the main storage device transforms external AC transmitted through the power input interface to DC by which all components in the main storage device are electrically activated and a data link interface on the main storage device is connected to an external network (402);
step 3: a power output interface on the main storage device is electrically connected to a power reception interface on an auxiliary storage device for transmission of external AC (403);
step 4: an auxiliary transformer unit of an auxiliary power management module in the auxiliary storage device transforms external AC transmitted through the power reception interface to DC by which all components in the auxiliary storage device are electrically activated and a main data bridging interface on the main storage device is electrically connected to an auxiliary data bridging interface on the auxiliary storage device (404).

2. An execution method of a storage device stacking system according to claim 1 wherein a data management module of the main storage device is used to manage a main storage module of the main storage device and an auxiliary storage module of the auxiliary storage device after step 4 (4051).

3. An execution method of a storage device stacking system according to claim 1 wherein an auxiliary data link interface on the auxiliary storage device is connected to an external network after step 4 (4052).

4. An execution method of a storage device stacking system according to claim 1 wherein the data link interface is available to a wired network or a wireless network or a combination thereof.

5. An execution method of a storage device stacking system according to claim 2 wherein an expanded power output interface on the auxiliary storage device is electrically connected to a power reception interface on a second auxiliary storage device for transmission of external AC after step 4 (405).

6. An execution method of a storage device stacking system according to claim 2 wherein an auxiliary data management module of the auxiliary storage device assists the data management module in data processing after step 4 (4053).

7. An execution method of a storage device stacking system according to claim 3 wherein the data management module of the main storage device is used to manage the data link interface and the auxiliary data link interface after step 4 (4054).

8. An execution method of a storage device stacking system according to claim 5 wherein an auxiliary transformer unit of an auxiliary power management module in the second auxiliary storage device transforms external AC transmitted through the power reception interface to DC by which all components in the second auxiliary storage device are electrically activated and an expanded data bridging interface on the auxiliary storage device is electrically connected to an auxiliary data bridging interface on the second auxiliary storage device after step 4 (406).

9. An execution method of a storage device stacking system according to claim 8 wherein the data management module is used to manage an auxiliary storage module of the second auxiliary storage device after step 4 (407).
